# EUROPÄISCHE PATENTANMELDUNG

(11) **EP 0 810 642 A2**
(43) Veröffentlichungstag der Anmeldung: **03.12.1997**
(21) Anmeldenummer: 97108338.1
(22) Anmeldetag: 22.05.1997
(51) Int. Cl.: H01L 21/306, H01L 21/00

(54) **Verfahren zum Ätzen eines Halbleitersubstrats sowie Ätzanlage**

(30) Priorität: 28.05.1996 DE 19621399
(71) Anmelder: SIEMENS AKTIENGESELLSCHAFT, 80333 München (DE)
(72) Erfinder: Sporer, Roland, 82383 Hohenpeissenberg (DE); Mathuni, Josef, Dr., 81737 München (DE); Gschwandtner, Alexander, Dr., 80687 München (DE)

(57) **Zusammenfassung**

Die vorliegende Erfindung gibt eine Vorrichtung und ein Verfahren an, mit dem auch dickere Schichten ein auf einer Halbleitersubstratrückseite bei belackungsfreier Halbleitersubstratvorderseite geätzt werden können. Dabei wird eine Ätzlösung in feinen Tröpfchen auf die Halbleitersubstratrückseite gesprüht. In einer bevorzugten Ausführungsform wird dabei das Halbleitersubstrat auf eine Temperatur ≤ 100°C erwärmt.

## Beschreibung

Die Erfindung betrifft ein Verfahren zum Ätzen einer Halbleitersubstratrückseite eines Halbleitersubstrats mit belackungsfreier Halbleitersubstratvorderseite sowie eine dazu geeigneten Ätzanlage.

Aus der DE-A-19502777.9 ist bereits ein Verfahren und eine Vorrichtung bekannt, bei der die zu entfernenden Schichten auf der Halbleitersubstratrückseite mit einem Mikrowellen- oder RF-angeregten Chemical-Down-Stream-Verfahren unter Verwendung von fluorhaltigen Verbindungen geätzt werden kann. Nachteilig ist bei diesem Verfahren, daß dicke thermische Oxidschichten aufgrund der zu niedrigen Ätzraten nicht entfernt werden können.

Aufgabe der vorliegenden Erfindung ist es daher, das eingangs erwähnte Verfahren dahingehend weiter zu entwickeln, daß auch dicke, insbesondere dicke thermische Oxidschichten, entfernt werden können.

Erfindungsgemäß wird die Aufgabe durch ein Verfahren zum Ätzen einer Halbleitersubstratrückseite eines Halbleitersubstrats mit belackungsfreier Halbleitersubstratvorderseite mit folgenden Schritten gelöst:
a) Das Halbleitersubstrat wird in eine Prozeßkammer eingebracht,
b) über die Halbleitersubstratvorderseite wird ein Schutzgas geleitet,
c) auf die Halbleitersubstratrückseite wird eine Ätzlösung gesprüht und Ätzprodukte und überschüssige Ätzlösungsbestandteile werden abgeführt.

Durch die Einführung dieses 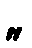 quasitrockenen" Verfahrens können auch dickere Schichten ökonomisch entfernt werden.

Vorzugsweise wird bei dem erfindungsgemäßen Verfahren das Halbleitersubstrat und/oder die Prozeßkammer auf eine Temperatur von ≤ 100°C erwärmt. Durch diese Maßnahme wird gewährleistet, daß die Ätzlosung mit der zu entfernenden Schicht auf der Halbleitersubstratrückseite chemisch gut reagieren kann und sich keine Ätzlösungstropfen auf dem Halbleitersubstrat bzw. an den Prozeßkammerwänden bilden. Eine weitere Reinigung von Halbleitersubstrat und Kammer kann entfallen.

Die erfindungsgemäße Anlage zum Ätzen der Halbleitersubstratrückseite eines Halbleitersubstrats mit belackungsfreier Halbleitersubstratvorderseite besteht aus:
α) einer Prozeßkammer,
β) die durch das eingebrachte Halbleitersubstrat in einen die Halbleitersubstratvorderseite enthaltenden ersten Prozeßkammerteil und einen die Halbleitersubstratrückseite enthaltenden zweiten Prozeßkammerteil unterteilt ist,
γ) einem im Bereich des ersten Prozeßkammerteils angeordneten Schutzgaseinlaß, durch den Schutzgas auf die belackungsfreie Halbleitersubstratvorderseite zum Schutz dieser vor einem Ätzangriff eingeleitet wird, sowie
δ) einem im Bereich des zweiten Prozeßkammerteils angeordneten Ätzlösungszerstäuber, durch den eine Ätzlösung auf die Halbleitersubstratrückseite gesprüht wird.

Ferner kann bei der erfindungsgemäßen Ätzanlage ein Mittel zur Aufheizung des Halbleitersubstrats und/oder der Prozeßkammer vorgesehen sein. Ein solches Mittel ist z.B. eine Heizlampe.

Andererseits kann aber auch das Beheizen des Halbleitersubstrats über einen Wärmeübertrag durch das Schutzgas auf das Halbleitersubstrat erfolgen. Eine Temperatur von ungefähr 100°C hat sich deswegen als besonders geeignet erwiesen, da hier überschüssige bzw. neben das Halbleitersubstrat gelangende Ätzmitteltröpfchen sofort verdampfen und damit das Halbleitersubstrat und die Prozeßkammer sofort nach Beendigung der Ätzung wieder trocken sind.

Ferner kann eine Evakuiervorrichtung oder eine Absaugvorrichtung mit der Prozeßkammer über einen im Bereich des Halbleitersubstratrandes angeordneten, ringförmigen Spalt verbunden sein. Durch diese Maßnahme werden die Ätzprodukte und überschüssige Ätzmittel dort abgeführt, wo sie unmittelbar entstehen.

In einer bevorzugten Ausführung sind im Bereich des ersten Prozeßkammerteils zumindest drei Stifte vorgesehen, auf dem die Halbleitersubstratrückseite aufliegt. Im Bereich des zweiten Prozeßkammerteils befindet sich vorzugsweise eine Kopfplatte mit zumindest einer mittigen Öffnung, die zentral über der Halbleitersubstratvorderseite angeordnet ist. Durch diese zwei Merkmale wird einerseits ein guter Sitz des Halbleitersubstrat in der Prozeßkammer gewährleistet, ohne daß größere Teile der zu ätzenden Halbleitersubstratrückseite abgedeckt sind, und zum anderen wird eine gute Überströmung der Halbleitersubstratvorderseite mit Schutzgas gewährleistet.

Vorzugsweise ist die Ätzanlage nach der vorliegenden Erfindung in eine sogenannte Mehrkammeranlage integriert, so daß Einbringen und Herausnehmen des zu ätzenden Halbleitersubstrats voll automatisch erfolgt, und auch andere weitere bzw. vorhergehende Prozeßschritte innerhalb dieser Mehrkammeranlage unmittelbar stattfinden können.

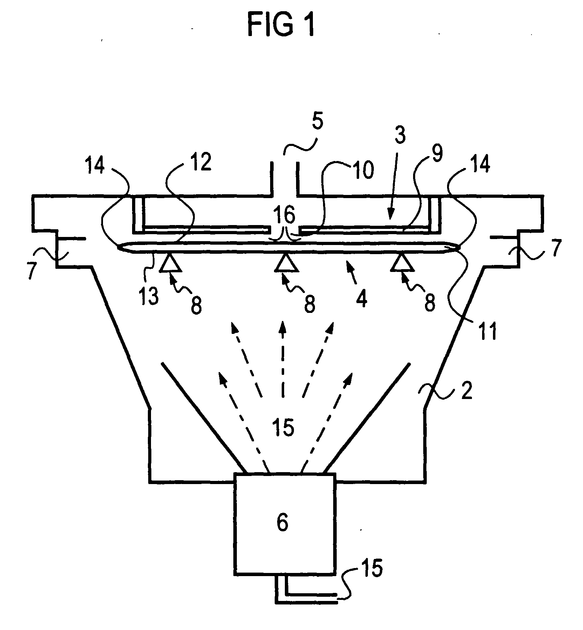

Die Erfindung ist in der Figur anhand eines Ausführungsbeispiels veranschaulicht und im nachstehenden im einzelnen anhand der Figur beschrieben. Die Figur zeigt dabei in schematischer Darstellung eine Ansicht der Vorrichtung nach der vorliegenden Erfindung.

Gemäß der Figur besteht die erfindungsgemäße Anlage 1 zum Ätzen aus einer Evakuiervorrichtung (nicht gezeigt), die mit einer Prozeßkammer 2 verbunden ist.

In die Prozeßkammer 2 ist ein Halbleitersubstrat 11 mit einer Halbleitersubstratrückseite 13 und einer belackungsfreien Halbleitersubstratvorderseite 12 eingebracht.

Im vorliegenden Ausführungsbeispiel weist die belackungsfreie Halbleitersubstratvorderseite 12 mit ihrem Gesicht nach oben, d.h. sie ist in ihrer natürlichen Lage in die Prozeßkammer eingebracht worden.

Durch das eingebrachte Halbleitersubstrat 11 wird die Prozeßkammer 2 in einen die Halbleitersubstratvorderseite 12 enthaltenden ersten Prozeßkammerteil 3 und einen die Halbleitersubstratrückseite 13 enthaltenden zweiten Prozeßkammerteil 4 unterteilt.

Im zweiten Prozeßkammerteil 4 befindet sich eine aus drei Stiften 8 bestehende Haltevorrichtung, auf dem die Halbleitersubstratrückseite 13 aufliegt.

Im Bereich des ersten Prozeßkammerteils 3 ist eine Kopfplatte 9 angeordnet, die mit einer mittigen Öffnung 10 versehen ist, die zentral über der Halbleitersubstratvorderseite 12 liegt.

Durch diese Öffnung 10 strömt das aus dem im Bereich des ersten Prozeßkammerteils 3 angeordneten Schutzgaseinlaß 5 kommende Schutzgas 16 auf die belackungsfreie Halbleitersubstratvorderseite 12 und schützt diese vor einem Ätzangriff.

Im Bereich des zweiten Prozeßkammerteils 4 ist ein Ätzlösungszerstäuber 6 angeordnet, durch den eine Ätzlösung 15 auf die Halbleitersubstratrückseite 13 in Form von feinen Tröpfchen gesprüht wird.

Die beim eigentlichen Ätzvorgang entstehenden Ätzprodukte sowie überschüssige Ätzlösung werden über die Evakuiervorrichtung abgesaugt, mit der die Prozeßkammer 2 in der Höhe des Halbleitersubstratrandes 14 durch einen dort angeordneten ringförmigen Spalt 7 verbunden ist.

Das Halbleitersubstrat 11 wird durch einen Wärmeübertrag durch das Schutzgas 16 auf eine Temperatur von ungefähr 100°C erwärmt. Im vorliegenden Fall ist die zu entfernende Schicht auf der Halbleitersubstratrückseite eine dicke thermische SiO₂-Schicht und die verwendete Ätzlösung 15 ist in ihrer Hauptsache eine wässrige Lösung, die ungefähr 50 Gewichts-% Flußsäure (HF) enthält. Während des Ätzens dieser SiO₂-Schicht wird nun die Ätzlösung 15 von unten her in feinen Tröpfchen auf das beheizte Halbleitersubstrat gesprüht. Dort reagiert es mit dem SiO₂ auf der Halbleitersubstratrückseite 13 und beides, Ätzprodukt, Wasser und überschüssige Flußsäure verdampfen auf dem heißen Halbleitersubstrat 11 und werden dann über den ringförmigen Spalt 7 abgesaugt.

Als Schutzgas 16 wird im vorliegenden Fall Stickstoff verwendet. Es ist jedoch auch der Einsatz von Argon oder anderen Inertgasen denkbar. Da die eigentliche Ätzreaktion bei relativ hohen Temperaturen stattfindet, ist die Ätzung vor allem bei einem Zusatz von Alkohol zur Ätzlösung rückstandsfrei.

### Bezugszeichenliste

- 1: = Evakuiervorrichtung
- 2: = Prozeßkammer
- 3: = erster Prozeßkammerteil
- 4: = zweiter Prozeßkammerteil
- 5: = Schutzgaseinlaß
- 6: = Ätzlösungszerstäuber
- 7: = ringförmiger Spalt
- 8: = Stifte
- 9: = Kopfplatte
- 10: = Öffnung
- 11: = Halbleitersubstrat
- 12: = Halbleitersubstratvorderseite
- 13: = Halbleitersubstratrückseite
- 14: = Halbleitersubstratrand
- 15: = Ätzlösung
- 16: = Schutzgas

## Patentansprüche

1. Verfahren zum Ätzen einer Halbleitersubstratrückseite (13) eines Halbleitersubstrats (11) mit belackungsfreier Halbleitersubstratvorderseite (12) mit folgenden Schritten:
a) Das Halbleitersubstrat (11) wird in eine Prozeßkammer (2) eingebracht,
b) über die Halbleitersubstratvorderseite (12) wird ein Schutzgas (16) geleitet,
c) auf die Halbleiter Substratrückseite (13) wird eine Ätzlösung (15) gesprüht und Ätzprodukte und überschüssige Ätzlösungsbestandteile werden abgeführt.

2. Verfahren nach Anspruch 1,
**dadurch gekennzeichnet,** daß das Halbleitersubstrat (11) auf eine Temperatur von ≤ 100°C erwärmt wird.

3. Anlage zum Ätzen einer Halbleitersubstratrückseite (13) eines Halbleitersubstrats (11) mit belackungsfreier Halbleitersubstratvorderseite (12) bestehend aus:
α) Einer Prozeßkammer (2),
β) die durch das eingebrachte Halbleitersubstrat (11) in einen die Halbleitersubstratvorderseite (12) enthaltenden ersten Prozeßkammerteil (3) und einen die Halbleitersubstratrückseite (13) enthaltenden zweiten Prozeßkammerteil (4) unterteilt ist,
γ) einen im Bereich des ersten Prozeßkammerteils (3) angeordneten Schutzgaseinlaß (5), durch den Schutzgas (16) auf die belackungsfreie Halbleitersubstratvorderseite (12) zum Schutz dieser vor einem Ätzangriff eingeleitet wird, sowie
δ) einem im Bereich des zweiten Prozeßkammerteils (4) angeordneten Ätzlösungszerstäuber (6), durch den eine Ätzlösung (15) auf die Halbleitersubstratrückseite (13) gesprüht wird.

4. Ätzanlage nach Anspruch 3,
**dadurch gekennzeichnet,** daß Mittel zur Aufheizung des Halbleitersubstrats und/oder der Prozeßkammer vorgesehen sind.

5. Ätzanlage nach Anspruch 3 oder 4,
**dadurch gekennzeichnet,** daß eine Absaugvorrichtung mit der Prozeßkammer (2) über einen im Bereich des Halbleitersubstratrandes (14) angeordneten, ringförmigen Spalt (7) verbunden ist.

6. Ätzanlage nach einem der Ansprüche 3 bis 5,
**dadurch gekennzeichnet,** daß im Bereich des ersten Prozeßkammerteils (3) zumindest drei Stifte (8) vorgesehen sind, auf dem die Halbleitersubstratrückseite (13) aufliegt.

7. Ätzanlage nach einem der Ansprüche 3 bis 6,
**dadurch gekennzeichnet,** daß im Bereich des zweiten Prozeßkammerteils (4) eine Kopfplatte (9) mit zumindest einer mittigen Öffnung (10), die zentral über der Halbleitersubstratvorderseite (12) angeordnet ist, vorgesehen ist, durch die das Schutzgas (16) einströmt.

8. Ätzanlage nach einem der Ansprüche 3 bis 7,
**dadurch gekennzeichnet,** daß die Ätzanlage Bestandteil einer Mehrkammeranlage ist.

9. Verwendung einer wässrigen Ätzlösung zum Ätzen einer thermischen Oxidschicht auf einer Halbleitersubstratrückseite (13) eines Halbleitersubstrates (11) mit belackungsfreier Halbleitersubstratvorderseite (12), die bis zu 50 Gewichts-% Flurwasserstoff enthält.
